(19) Europäisches Patentamt
European Patent Office
Office européen des brevets

(11) **EP 0 549 045 B1**

(12) **FASCICULE DE BREVET EUROPEEN**

(45) Date de publication et mention
de la délivrance du brevet:
**27.11.1996 Bulletin 1996/48**

(51) Int Cl.⁶: **H03F 3/45**, H03F 1/02

(21) Numéro de dépôt: **92203929.2**

(22) Date de dépôt: **15.12.1992**

(54) **Dispositif semiconducteur comprenant un amplificateur différentiel à deux étages**

Halbleiteranordnung mit zweistufigen Differenzverstärker

Semi-conductor device comprising a differential amplifier with two stages

(84) Etats contractants désignés:
**DE FR GB IT**

(30) Priorité: **23.12.1991 FR 9116035**

(43) Date de publication de la demande:
**30.06.1993 Bulletin 1993/26**

(73) Titulaires:
• **LABORATOIRES D'ELECTRONIQUE PHILIPS
S.A.S.
94450 Limeil-Brévannes (FR)**
Etats contractants désignés:
**FR**
• **Philips Electronics N.V.
5621 BA Eindhoven (NL)**
Etats contractants désignés:
**DE GB IT**

(72) Inventeur: **Philippe, Pascal
F-75008 Paris (FR)**

(74) Mandataire: **Landousy, Christian et al
Société Civile S.P.I.D.
156, Boulevard Haussmann
75008 Paris (FR)**

(56) Documents cités:
EP-A- 0 244 973          DE-A- 2 734 945
US-A- 5 068 621

• **PATENT ABSTRACTS OF JAPAN vol. 9, no. 189
(E-333)(1912) 6 Août 1985 & JP-A-60 057 709**

## Description

L'invention concerne un dispositif semiconducteur comprenant un amplificateur différentiel à deux étages, ayant une première paire différentielle de transistors couplés par leur source, recevant chacun un signal d'entrée, et une seconde paire différentielle de transistors couplés par leur source, recevant chacun la sortie d'une des branches de la première paire différentielle et fournissant chacun une sortie.

Des amplificateurs différentiels multi-étages sont connus par exemple de l'ouvrage intitulé "Operational amplifiers", Design and Applications par G. GRAEME et alii, publié chez Mac GRAW-HILL BOOK COMPANY, New-York. Le chapitre 4 de cet ouvrage est consacré aux amplificateurs différentiels multi-étages. Un amplificateur différentiel est par exemple formé de deux transistors couplés par leurs émetteurs et chacun muni de charges sur leur collecteurs. Les bases reçoivent chacune un signal d'entrée et les sorties sont disponibles sur les collecteurs. Un amplificateur différentiel multi-étages est simplement formé de deux ou plus de ces étages tels que la sortie d'une branche d'un premier étage est reportée sur l'entrée d'une branche d'un second étage.

Or la présente invention propose un circuit applicable dans le domaine des téléphones sans fil, des récepteurs pour automobiles, ou tout autre récepteur nécessitant des circuits équilibrés, à faible consommation et d'un faible coût de fabrication pour applications grand public.

Un des buts de l'invention est de fournir un circuit ayant un gain différentiel aussi élevé que celui des circuits connus, mais ayant, en revanche, une consommation moindre.

Un autre but de l'invention est de fournir un circuit ayant un bon facteur de bruit.

Un autre but de l'invention est de fournir un circuit qui montre une rejection de mode commun supérieure à ce qui était connu de l'état de la technique.

Ces buts sont atteints au moyen d'un dispositif tel que défini dans le préambule et ayant en outre les caractéristiques de la revendication 1. Dans ce dispositif, chaque branche de la deuxième paire différentielle est mise en série avec une branche de la première paire différentielle, de manière à former deux sous-circuits incluant chacun un transistor de la première paire et sa charge, et un transistor de la deuxième paire et sa charge, pour que les deux transistors de chaque sous-circuit partagent le même courant.

Le circuit différentiel réalisé présente entre autres avantages :

- un fort gain,
- un fort taux de rejection en mode commun.

L'invention est décrite ci-après en détail, en référence avec les figures annexées dont :

- la figure 1 représente un amplificateur,
- la figure 2 représente un amplificateur différentiel selon l'invention,
- la figure 3 représente les schémas équivalant à l'amplificateur différentiel en mode différentiel et en mode commun,
- la figure 4 représente un exemple de réalisation,
- les figures 5a et 5b représentent des courbes de gain en fonction de la fréquence pour deux exemples de mise en oeuvre du circuit de la figure 4.

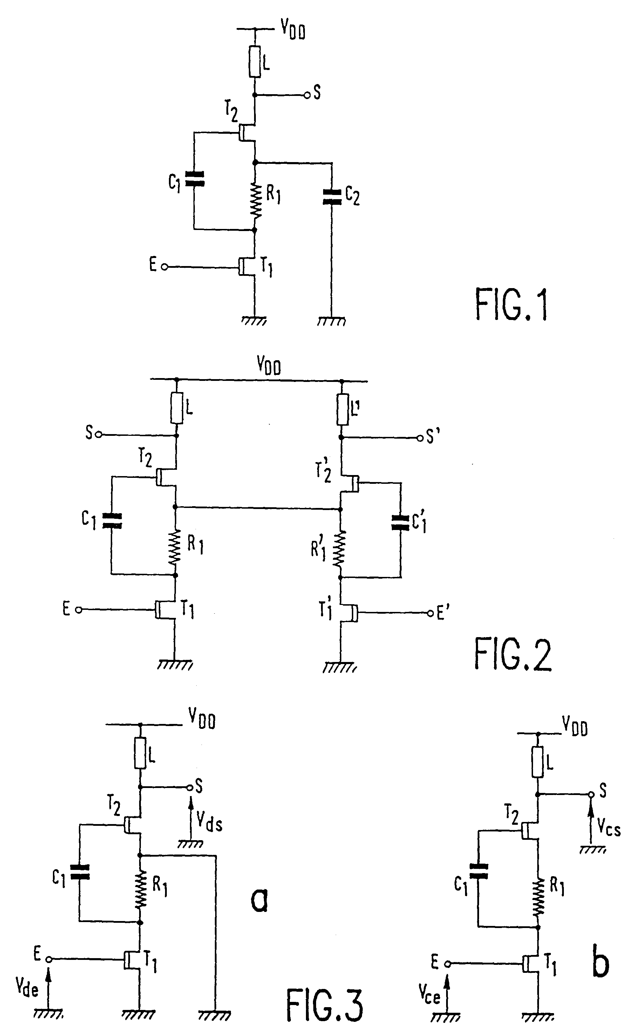

Le circuit amplificateur de la figure 1 est composé de deux transistors T1 et T2 à effet de champ. Le transistor T1 est monté en source commune à la masse. Le transistor T2 est relié au transistor T1 par la charge résistive R1 connectée entre la source de T2 et le drain de T1. Le signal à amplifier est appliqué en E sur la grille de T1. Le signal amplifié est recueilli sur le drain de T1 et envoyé sur la grille de T2 au travers d'une capacité d'isolation $C_1$. Le transistor haut T2 doit avoir sa source reliée à la masse en alternatif pour avoir du gain. La mise à la masse de T2 est effectuée par la capacité $C_2$ de faible impédance. La sortie de l'amplificateur s'effectue en S sur le drain de T2. Le transistor T2 est muni d'une charge L connectée entre son drain et une alimentation continue $V_{DD}$.

En référence avec la figure 2, le circuit amplificateur différentiel selon l'invention a une structure symétrique et est composé de deux soins-circuits identiques couplés l'un à l'autre. Chacun des sous-circuits est un amplificateur selon la figure 1, comprenant un premier transistor, respectivement T1 et T'1, muni d'une charge respectivement R1 et R'1, et comprenant en série un second transistor respectivement T2 et T'2, muni de sa charge respectivement L et L'. Chaque branche ainsi formée de quatre éléments en série est connectée d'une part à la masse et d'autre part à l'alimentation $V_{DD}$. La capacité $C_2$ mettant à la masse la source de T2 ou T'2 est supprimée. L'amplificateur différentiel selon l'invention est obtenu par couplage de deux sous-circuits. Ce couplage est réalisé en réunissant les sources des transistors hauts T2 de chacun des sous-circuits au même point, les sources des transistors bas T1, T'1 étant à la masse. Ce circuit est symétrique et peut être analysé par la méthode classique consistant à étudier séparément le fonctionnement en modes différentiel et commun.

### Mode différentiel

Le circuit équivalent en mode différentiel est illustré par la figure 3a. Le point de couplage, c'est-à-dire la source des transistors T2 de chacun des sous-circuits, devient une masse virtuelle. Les deux sous-circuits sont isolés l'un de l'autre, si bien que l'analyse du circuit se réduit à l'analyse d'un sous-circuit. Le gain en tension différentiel Gd est équivalent à la mise en cascade de deux amplificateurs à source commune, donc élevé. En négligeant l'effet des capacités parasites des transistors, on obtient :

$$G_d = [-g_{m1}R_1/(1+g_{d1}\,R_1)] \times [-g_{m2}R_2/(1+g_{d2}R_2)]$$

où $g_{m1}$, $g_{d1}$ sont respectivement les transconductance et conductance de sortie du transistor T1, $g_{m2}$ et $g_{d2}$ désignant les mêmes paramètres pour le transistor T2.

## Mode commun

Le circuit équivalent en mode commun est illustré par la figure 3b. Dans la branche couplant les sources des transistors T2, il ne passe aucun courant, si bien qu'elle peut être retirée sans affecter le comportement du circuit. Les sources du transistor T2 sont donc en l'air en mode commun. L'analyse se réduit, comme en mode différentiel, à considérer un seul sous-circuit. Le comportement en mode commun est très différent du comportement en mode différentiel, notamment par le fait que le transistor haut T2 a un gain très faible dû à la contre-réaction provoquée par la résistance R1. Le gain en tension de mode commun Gc est donné, en négligeant l'effet des capacités parasites des transistors, par :

$$G_c = [-g_{m1}/(g_{d1}+g_{d2}/K)] \times [g_{d2}.R_2/K]$$

$$\text{avec } K = 1 + (g_{m2}+g_{d2})R1 + g_{d2}\,R2$$

Le paramètre K étant très supérieur à 1, on peut simplifier l'expression ci-dessus en :

$$G_c = [-g_{m1}.g_{d2}R_2/K.g_{d1}]$$

Dans le cas où les transistor T1 et T2 sont identiques, où les conditions de polarisation sont identiques, et où R1 = R2 (ce qui sera le cas dans la mise en oeuvre décrite plus loin), les gains en mode différentiel et mode commun sont donnés par :

$$G_d = [-g_m R/(1+g_d.R)]^2$$

$$G_c = [-g_m R/(1+g_m.R+2g_d.R)]$$

Le rapport **R** des gains, de mode différentiel et de mode commun est donné par :

$$\underline{R} = G_d/G_c = -\,g_m R[1+(g_m+2g_d).R]/[1+g_d R]^2$$

L'amplificateur différentiel réalisé selon la figure 2 présente entre autres les avantages suivants :

- un gain différentiel élevé, équivalent à celui de deux étages montés en source commune tels que connus de l'état de la technique,

- une réjection de mode commun élevée, obtenue sans qu'il soit besoin d'utiliser des sources de courant à forte impédance de sortie comme il était connu de l'état de la technique,

- une consommation réduite, en regard du gain obtenu, du fait que les transistors T1 et T2 de chaque sous-circuit partagent le même courant,

- un facteur de bruit très faible, même en mode commun, provenant du fait que la contre-réaction à l'origine du faible gain de mode commun est appliquée sur le transistor haut T2 (ou T'2), c'est-à-dire en quelque sorte sur le deuxième étage d'amplification. Le fonctionnement de T1 reste donc faible bruit même en mode commun, et contribue, par effet de masque dû à son gain, à maintenir un bon facteur de bruit de mode commun.

Dans une variante du circuit de la figure 2, on peut connecter une source de courant, entre les sources couplées des transistors bas T1 et T'1. La tension d'alimentation $V_{DD}$ devra alors être plus élevée.

## Exemple de réalisation

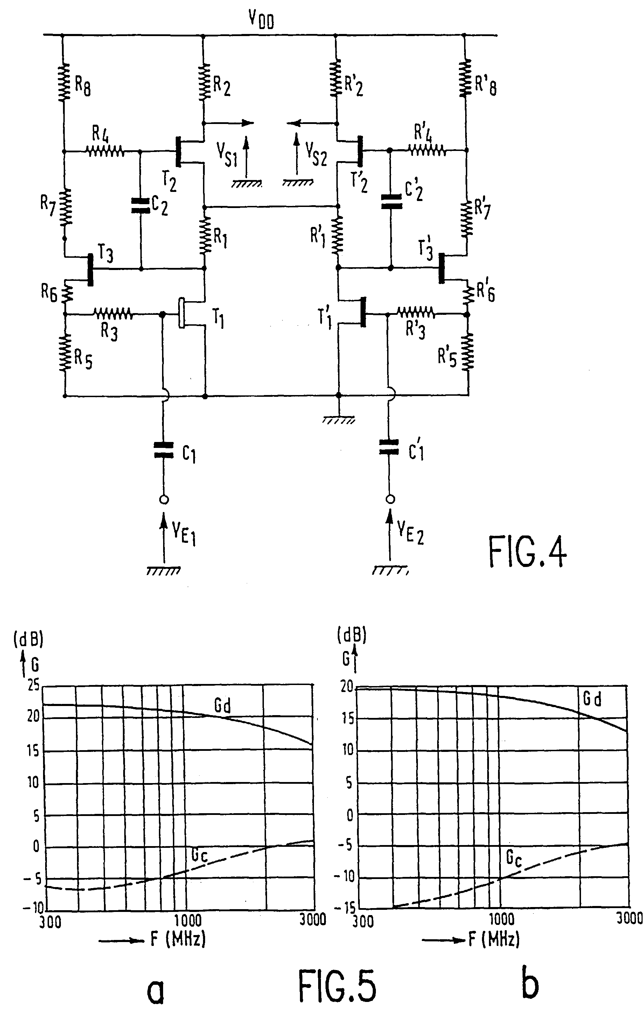

Un exemple de réalisation d'amplificateur différentiel fondé sur l'amplificateur décrit en référence avec la figure 2, est illustré par la figure 4. Ce circuit est réalisé au moyen de transistors à effet de champ en arséniure de gallium (GaAs) à enrichissement, c'est-à-dire normalement bloqués en l'absence de tension grille-source.

Les transistors T1, T'1, T2, T'2 sont choisis identiques avec une largeur de grille de l'ordre de 100 µm. Ils sont polarisés au moyen d'un circuit incluant les transistors T3 et T'3.

Le Tableau I donne des valeurs des éléments pour réaliser le circuit de la figure 4 groupées selon deux exemples de mise en oeuvre. Les valeurs données dans le tableau I ne sont donc pas limitatives.

La figure 5a représente les gains $G_c$ et $G_d$ en fonction de la fréquence F, obtenus avec le circuit de la figure 4 réalisé au moyen des valeurs des éléments correspondant à l'exemple 1 du Tableau I.

La figure 5b représente les gains $G_c$ et $G_d$ en fonction de la fréquence F, obtenus avec le circuit de la figure 4 réalisé au moyens des valeurs des éléments correspondant à l'exemple 2 du Tableau I.

Les gains sont mesurés par les rapports des signaux d'entrée $V_{E1}$ ou $V_{E2}$ aux signaux de sortie $V_{S1}$ ou $V_{S2}$ (voir la figure 4).

TABLEAU I

| Exemple | $T_1$ $T'_1$ | $T_2$ $T'_2$ | $T_3$ $T'_3$ | $R_1$ $R'_1$ | $R_2$ $R'_2$ | $R_3$ $R'_3$ | $R_4$ $R'_4$ | $R_5$ $R'_5$ | $R_6$ $R'_6$ | $R_7$ $R'_7$ | $R_8$ $R'_8$ | $C_1$ $C'_1$ | $C_2$ $C'_2$ |
|---|---|---|---|---|---|---|---|---|---|---|---|---|---|
| n°1 | 100µm | 100µm | 20µm | 500Ωm | 500Ωm | 5kΩ | 5kΩ | 1kΩ | 1kΩ | 1kΩ | 4kΩ | 2pF | 2pF |
| n°2 | " | " | " | 750Ωm | 250Ωm | " | " | " | " | 2kΩ | 3kΩ | " | " |

**Revendications**

1. Dispositif semiconducteur comprenant un amplificateur différentiel à deux étages, ayant une première paire différentielle de transistors couplés par leur source, recevant chacun un signal d'entrée, et une seconde paire différentielle de transistors couplés par leurs source, recevant chacun la sortie d'une des branches de la première paire différentielle, et fournissant chacun une sortie, caractérisé en ce que chaque branche de la deuxième paire différentielle est mise en série avec une branche de la première paire différentielle, de manière à former deux sous-circuits incluant chacun un transistor de la première paire et sa charge, et un transistor de la deuxième paire et sa charge, pour que les deux transistors de chaque sous-circuit partagent le même courant.

2. Dispositif selon la revendication 1, caractérisé en ce que les sources des transistors de la première paire sont couplées à une source de courant.

3. Dispositif selon l'une des revendications 1 ou 2, caractérisé en ce que les transistors sont des transistors à effet de champ.

4. Dispositif selon la revendication 3, caractérisé en ce que les transistors à effet de champ sont en arséniure de gallium, du type normalement bloqué en l'absence de tension grille-source.

5. Dispositif selon l'une des revendications 1 à 4, caractérisé en ce que les transistors sont munis de moyens de polarisation de grille.

**Patentansprüche**

1. Halbleiteranordnung mit einem zweistufigen Differenzverstärker, der ein erstes Differenzierpaar von über ihre Source verbundenen Transistoren umfaßt, von denen jeder ein Eingangssignal empfängt, und ein zweites Differenzierpaar von über ihre Source verbundenen Transistoren, von denen jeder das Ausgangssignal einer der Zweige des ersten Differenzierpaars empfängt und jeder ein Ausgangssignal liefert, dadurch gekennzeichnet, daß jeder Zweig des zweiten Differenzierpaars so in Reihe mit einem Zweig des ersten Differenzierpaars geschaltet ist, daß zwei Teilschaltungen gebildet werden, von denen jede einen Transistor des ersten Paars und seine Last sowie einen Transistor des zweiten Paars und seine Last umfaßt, damit die beiden Transistoren jeder Teilschaltung sich den gleichen Strom teilen.

2. Anordnung nach Anspruch 1, dadurch gekennzeichnet, daß die Sources der Transistoren des ersten Paars an eine Stromquelle gekoppelt sind.

3. Anordnung nach Anspruch 1 oder 2, dadurch gekennzeichnet, daß die Transistoren Feldeffekttransistoren sind.

4. Anordnung nach Anspruch 3, dadurch gekennzeichnet, daß die Feldeffekttransistoren aus Galliumarsenid sind und von einem Typ, der normalerweise gesperrt ist, wenn keine Gate-Source-Spannung anliegt.

**5.** Anordnung nach einem der Ansprüche 1 bis 4, <u>dadurch gekennzeichnet</u>, daß die Transistoren mit Gate-Polarisierungsmitteln versehen sind.

## Claims

**1.** A semiconductor device comprising a two-stage differential amplifier, the amplifier comprising a first differential transistor pair whose transistors are coupled by their source electrodes, each of the transistors receiving an input signal, and a second differential transistor pair whose transistors are coupled by their source electrodes, each of the transistors receiving the output of one of the branches of the first differential pair, and each supplying an output, characterised in that each branch of the second differential pair is arranged in series with a branch of the first differential pair so as to form two sub-circuits each including a transistor of the first pair and its load, and a transistor of the second pair and its load, in such a manner that the two transistors of each sub-circuit share the same current.

**2.** A device as claimed in Claim 1, characterised in that the source electrodes of the transistors of the first pair are coupled to a current source.

**3.** A device as claimed in Claim 1 or 2, characterised in that the transistors are field-effect transistors.

**4.** A device as claimed in Claim 3, characterised in that the field-effect transistors are gallium-arsenide transistors of the type normally cut off in the absence of a gate-source voltage.

**5.** A device as claimed in any one of the Claims 1 to 4, characterised in that the transistors are provided with gate bias means.

FIG.1

FIG.2

FIG.3

FIG.4

a       FIG.5       b